# EUROPEAN PATENT APPLICATION

(11) **EP 2 757 582 A1**
(43) Date of publication of application: **23.07.2014**
(21) Application number: 13151563.7
(22) Date of filing: 17.01.2013
(51) Int. Cl.: H01L 23/047, H01L 23/053, H01L 23/057

(54) **Packaged electrical components**

(71) Applicant: NXP B.V., 5656 AG Eindhoven (NL)
(72) Inventor: Weinschenk, Christian, 5656 AG Eindhoven (NL); Asis, Michael, 5656 AG Eindhoven (NL); Reijs, Albertus, 5656 AG Eindhoven (NL)
(74) Representative: Schouten, Marcus Maria

(57) **Abstract**

An electrical component package has a connection lead structure which is formed with a height step 30 at the location where the connection lead structure exits the package. The size of the height is dependent on the sum of the thickness tolerance variations of the first set of layers and the base, such that after the height step, the height of the connection lead structure with respect to the base of the package is independent of these thickness tolerance variations. This reduces the required tolerances for the soldering and assembly processes.

## Description

This invention relates to packaged electrical components, for example air cavity packages used for housing integrated circuits or components.

In RF power applications, power amplifier products are often packaged in air cavity packages. Air cavity packages are typically built-up by a stack of different materials, for example a heat sink layer, dielectric ring, interconnect layers, leads and lid. The package encapsulates semiconductor dies, internal wiring and an air cavity.

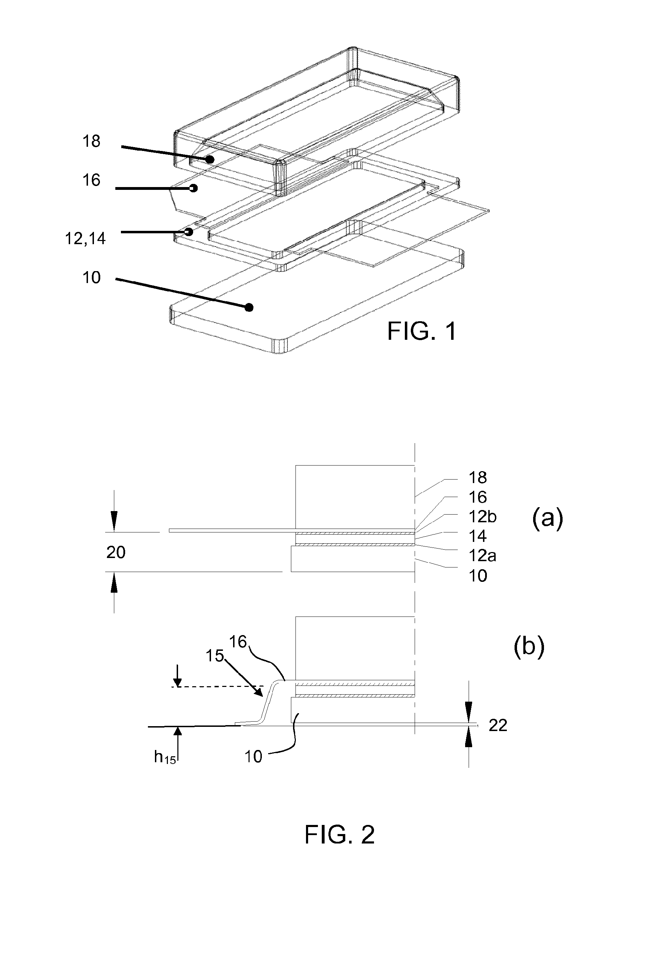

Figure 1 shows a typical air cavity package. The base of the structure comprises a heat sink 10, on which are provided interconnect layers 12 and a dielectric ring 14. The ring surrounds an internal cavity. The leads 16 provide interconnections between the exterior of the cavity to the interior, and a lid 18 seals the cavity.

When attaching the leads 16 onto the dielectric ring 14, the leads are all connected in one frame. The leads are separated from the connecting frame directly after attaching the leadframe onto the dielectric ring or later in the product assembly process after assembling the complete product including dies, wires and lid.

The distance between the bottom side of the heat sink 10 and the bottom side of the leads16, often referred to as seating plane height or standoff height, is a key parameter for the design of the printed circuit board (PCB) and cooling block (to which the package is mounted) and the automated board soldering process.

Due to the stack-up of multiple materials, the actual seating plane height of a package can have a large deviation compared to the design value and the requirements for board assembly, which can cause incomplete solder on the leads or heat sink.

According to the invention there are provided an apparatus and method as defined in the claims.

In one aspect, the invention provides an electrical component formed in a package, wherein the package comprises a base, a first set of layers forming an enclosure, a connection lead structure formed over the first set of layers which connects to the component within the package and defines connection terminals outside the package, and a lid over the connection lead structure,
wherein the connection lead structure extends laterally from the package and has a height step at the location where the connection lead structure exits the package, wherein the size of the height step is dependent on the sum of the thickness tolerance variations of the first set of layers and the base, such that after the height step, the height of the connection lead structure with respect to the base is independent of said thickness tolerance variations.

The invention thus provides an additional height step in a connection lead structure to adjust for the deviation from the design value of the height, thereby to simplify the requirements for board assembly. The additional height step results in a reduced tolerance on the seating plane height. This height step can be made by means of a tool which bends the lead to a fixed height relative to the bottom of the base (such as a heat sink), which thus acts as a reference position for the tool.

The size of the height step is preferably less than one quarter of the sum of the thicknesses of the first set of layers and the base. Thus, the height step is intended for tolerance compensation rather than significant height adjustment.

The first set of layers can comprise a first interconnect layer over the base, a dielectric ring formed over the first interconnect layer, and a second interconnect layer formed over the dielectric ring. This can for example define an air cavity structure. The base can comprise a heat sink.

In one example, the connection lead structure can comprise a second height step such that the bottom of the connection lead structure after the second height step is level with the bottom of the base. This second height step is part of a so-called gull wing lead structure, from here onwards termed a "gull wing step".

In another example, the connection lead structure is flat after the height step. This defines a flat lead structure.

The invention also provides a circuit comprising:
a packaged electrical component of the invention; and
a PCB to which the lead connection terminals are connected outside the package.

In a first example, the PCB and the package are mounted over a common base, wherein the package is mounted in a recess in the common base, and wherein the connection lead structure is flat after the height step. In this case, the height step is the only height adjustment made in the connection lead structure.

In a second example, the PCB and the package are mounted over a planar common base, wherein the connection lead structure comprises a gull wing step such that the bottom of the connection lead structure after the second height step is level with the bottom of the base.

The invention also provides a method of forming a component package, comprising
providing a base, a first set of layers over the base forming an enclosure, a connection lead structure over the first set of layers and a lid over the connection lead structure;
connecting the connection lead structure to a component within the package, wherein the connection lead structure defines connection terminals outside the package;
forming a height step at a location where the connection lead structure exits the package using a tool which is positioned with reference to the base, wherein the size of the height is dependent on the sum of the thickness tolerance variations of the first set of layers and the base, such that after the height step, the height of the connection lead structure with respect to the base is independent of said thickness tolerance variations.

This method makes use of a tool which provides a height step relative to the base such the tolerances of the layers are compensated.

Examples of the invention will now be described in detail with reference to the accompanying drawings, in which:
Figure 1 shows a known air cavity package;
Figure 2 is used to explain problems associated with tolerance variations in two types of package;
Figure 3 shows a first known type of package and the modification provide by the invention;
Figure 4 shows a second known type of package and the modification provide by the invention;
Figure 5 shows the package of the invention of Figure 3 connected into a circuit; and
Figure 6 shows the package of the invention of Figure 4 connected into a circuit.

The invention provides a packaged component. The package has a connection lead structure which is formed with a height step at the location where the connection lead structure exits the package. The size of the height step is dependent on the sum of the thickness tolerance variations of the first set of layers and the base, such that after the height step, the height of the connection lead structure with respect to the base of the package is independent of these thickness tolerance variations. This reduces the required tolerances for the soldering and assembly processes.

In the structure shown in Figure 1, the leads 16 have to be soldered with solder paste onto the PCB. The heat sink 10 has to be soldered by means of a solder preform or solder paste onto a cooling block which is accessible through an opening in the board.

Figure 2 shows the structure in side view for two types of connection lead structure. Figure 2(a) shows a straight lead package and Figure 2(b) shows a gull wing lead package. In a gull wing lead package, the leads are formed with a fixed height step 15 to bring the leads16 down to the base level (i.e. the base of the heat sink 10). The height of the step is shown as h₁₅.

Two interconnect layers 12a,12b are shown, between which is sandwiched the dielectric ring 14.

The interconnect layers 12a and 12b can consist of solder or adhesive. They may not be required, in the case that the dielectric ring consists of a molding compound which in itself adheres to the heatsink 10 and leads 16.

The seating plane height (the distance between the bottom side of the heat sink 10 and the bottom side of the leads 16) is shown as 20 in Figure 2(a). For a package with straight leads as in Figure 2(a), the cooling block contains a fixed depth recess to compensate for the height difference between leads and heat sink. When a gull wing step is formed as shown in Figure 2(b), any tolerance in the initial height 20 translates to tolerance 22 in the alignment between the base of the heat sink and the base of the leads 16 - which are supposed to be co-planar by forming the gull wing step.

For the gull wing formation, the leads are clamped at the top and the step is formed with reference to that clamped region.

The actual height of the seating plane of a package is determined by the actual height of each of the following materials which are between the bottom side of the leads 16 and the bottom side of the heat sink base 10:
- Interconnect layer 12b between leads 16 and dielectric ring 14;
- Dielectric ring 14;
- Interconnect layer 12a between the dielectric ring 14 and heat sink 10;
- Heat sink base 10.

The thickness variations of the materials depend on the production processes.

Due to the stack of multiple materials each with their own tolerances, the actual seating plane height of a package can have a large deviation compared to the design value. This also leads to large differences in seating plane height between different packages. As a result, the actual seating plane height of a package can have a large deviation compared to the requirement specification for board assembly.

These seating plane height differences cause a gap between the leads and the solder paste and can therefore cause soldering problems in the board assembly line, e.g. incomplete solder on the leads or heat sink. It is not possible to just bend the lead upwards to solve the problem because that will cause incomplete solder at the higher part of the lead. The lead should be kept straight and parallel to the PCB to which it is being soldered.

The invention provides an additional step 30 in height in the lead shape to adjust for the deviation from design values. The process of forming the height step 30 is performed after the complete product assembly and after lead separation from the connecting frame.

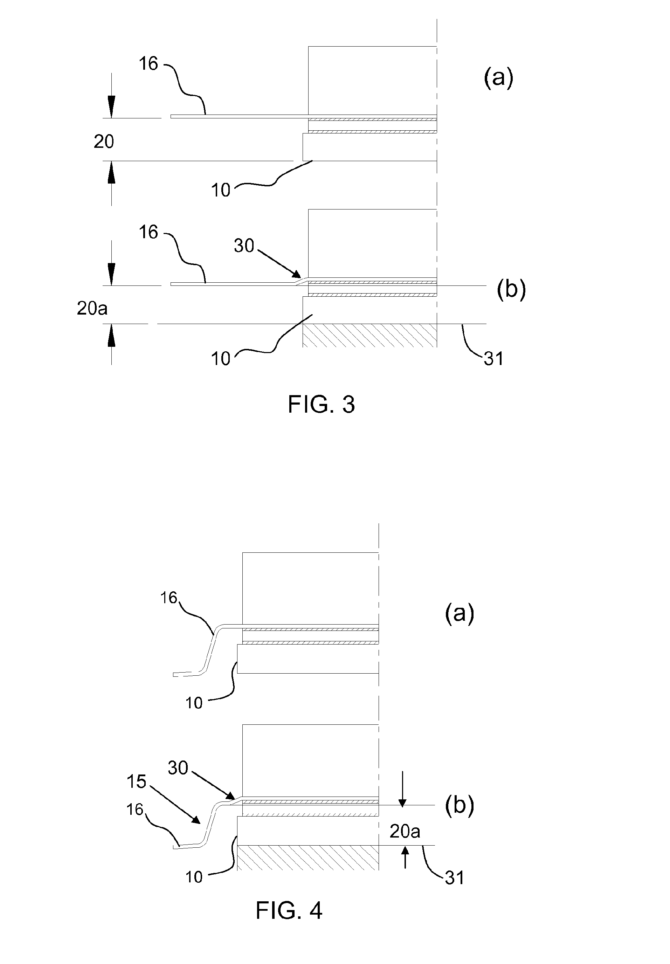

Figure 3 shows the approach of the invention applied to a straight lead package. Figure 3(a) corresponds to Figure 2(a) and shows the same seating plane height 20 between the leads 16 and heat sink 10.

Figure 3(b) shows an example of arrangement of the invention. The lead 16 has a step 30. The step 30 is made by means of a tool which bends the leads to a fixed height 20a relative to the bottom of the heat sink 10, which is the reference for the bending tool. This reference plane is shown by line 31. By referencing the bending tool to the base of the heat sink 10, the tool automatically compensates for tolerances.

The height of the actual adjustment step 30 for each package depends on the difference between the actual seating plane height 20 of the package instance and the target or design seating plane height 20a. This step results in a reduced tolerance on the seating plane height.

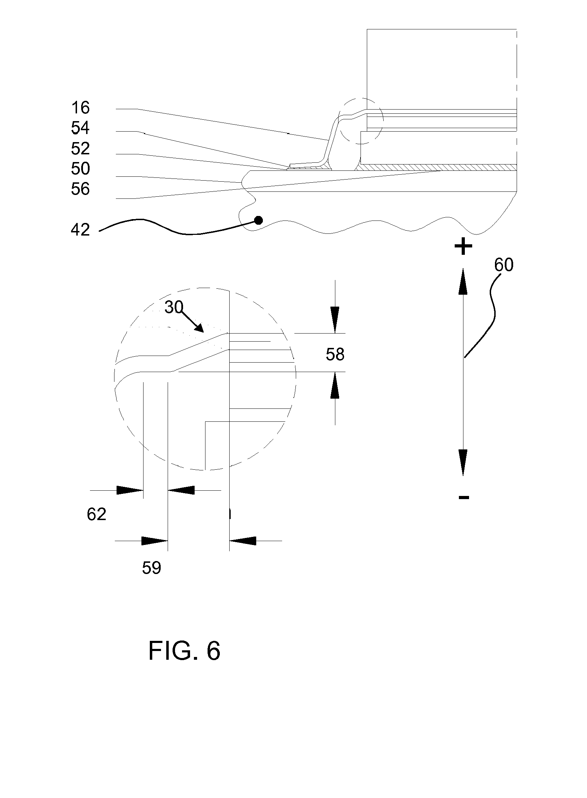

For packages with a gull wing lead shape as shown in Figure 2(b), the adjustment step 30 can be made before formation of the gull wing. The gull wing formation is then formed with the leads clamped after the adjustment step 30 (i.e. clamped in region 62 shown in Figure 6).

Figure 4 shows the approach of the invention applied to a gull wing lead package. Figure 4(a) corresponds to Figure 2(b).

Figure 4(b) shows an example of arrangement of the invention. The lead 16 again has a step 30. The step 30 is again made by means of a tool which bends the leads to a fixed height 20a relative to the bottom of the heat sink 10, which is the reference 31 for the bending tool. By referencing the bending tool to the base of the heat sink 10, the tool automatically compensates for tolerances.

By forming the step 30 before formation of the gull wing step 15, the gull wing formation starts from a compensated height. This means that the only tolerance in the final height 22 (as shown in Figure 2(b)) arises from the gull wing formation process.

The step 30 in the lead 16 should meet requirements regarding the length of the step 30. The additional step 30 in the lead causes an increase in the total length of the electrical path and therefore an increase in the inductance of the path from device to the board.

In order to limit this inductance increase, the electrical path from the package body to the PCB metallization pad and therefore the lead step length 59 should be as short as possible.

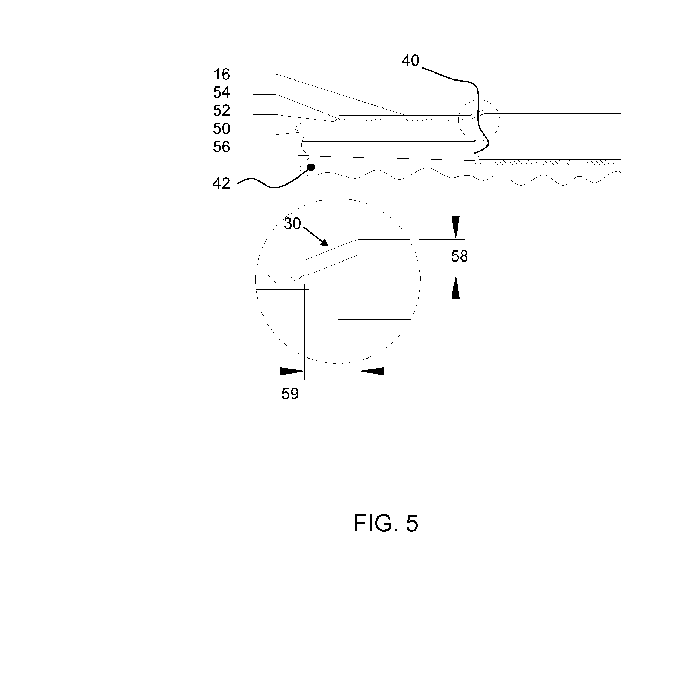

Figure 5 shows the straight lead package of the invention (of Figure 3(b)) connected to a PCB. As mentioned above, the package is formed in a fixed depth recess 40 of the supporting cooling block 42.

The PCB 50 is mounted over this cooling block, and has a board metallization pad 52 to which the lead 16 is soldered, by solder interconnect 54.

The package is soldered into the recess 40 by solder interconnect 56.

The edge of the package is shown enlarged in Figure 5 to show the step height 58 and the step length 59. By way of example, the step length 59 should be smaller than 2.0mm.

The step height 58 can be only for compensating for tolerances. In this case, the size of the step height 58 can be at most equal to the sum of the thickness tolerances of the first set of layers and the base, and as a minimum can be zero. Thus, after the height step 30, the height of the connection lead structure with respect to the base is independent of said thickness tolerances. However, the step height 58 can be a fixed amount greater than the sum of the tolerances.

For example, the seating plane height with no tolerance variations may be 1.58mm and the total tolerances may be ±0.13mm. In this case, the fixed height 20a (in Figure 3) can be 1.45mm so that the step height 58 is in the range 0 to 0.26mm (depending on the actual layer thicknesses). However, the fixed height 20a can be lower, for example 1.40mm. In this case, the step height 58 will be in the range 0.05mm to 0.31 mm (depending on the actual layer thicknesses).

The fixed height 20a is designed to match the recess depth, PCB thickness and solder interconnect thicknesses.

The height step 30 is primarily for tolerance compensation and is not intended to provide a significant additional height change. For example, the step height 58 is less than one quarter of the sum of the thicknesses of the first set of layers and the base.

For the gull wing lead version, additional requirements for the step 30 are present apart from the length requirement.

Figure 6 shows the gull wing lead package of the invention (of Figure 4(b)) connected to a PCB. The package is formed on a planar supporting cooling block 42.

The PCB 50 is mounted over this cooling block 42, and again has a board metallization pad 52 to which the lead 16 is soldered, by solder interconnect 54.

The package is soldered onto the block 42 by solder interconnect 56.

The edge of the package is shown enlarged in Figure 6 to show the step height 58 and the step length 59.

In this case, the step 30 may be required in either direction. Thus, the step direction can be positive or negative as shown by arrow 60.

In order to limit the inductance increase, the electrical path from the package to the PCB metallization pad should be as short as possible. Therefore the step direction is preferably in the down direction (i.e. negative using the notation shown in Figure 6).

To achieve this, the gull wing fixed height step 15 should correspond to (or be less than) the minimum seating plane height taking into account the various tolerances. In this way, any adjustment provided by the additional step 30 results in a downward step 30 from the package to the PCB.

Taking the example above, the seating plane height with no tolerance variations may be 1.58mm and the total tolerances may be ±0.13mm. In this case, the fixed height 20a (in Figure 4) can again be 1.45mm so that the step height 58 is in the range 0 to 0.26mm (depending on the actual layer thicknesses), and the gull wing step 15 provides the additional 1.45mm. However, the height drop can be shared differently between the tolerance adjustment step 30 and the gull wing step 15. For example with the fixed height 20a at 1.40mm, the step height 58 for the step 30 will be in the range 0.05mm to 0.31 mm (depending on the actual layer thicknesses) and the gull wing step15 will be 1.40mm.

As mentioned above, the height step 30 is primarily for tolerance compensation and is not intended to provide a significant additional height change. For example, the height step 30 is again less than one quarter of the sum of the thicknesses of the first set of layers and the base. The main height adjustment is thus carried out by the gull wing deformation step 15.

A second additional requirement for the gull wing lead package version is related to the shoulder length. This is the length between the additional step 30 and the gull wing deformation. It is shown as 62 in Figure 6.

The length of the step 30 should be such that sufficient shoulder length 62 remains for tooling to clamp the lead and to form the gull wing shape. By way of example, the shoulder length 62 should be larger than 0.4mm.

Typical examples for components in a such a package are RF power basestations.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. Any reference signs in the claims should not be construed as limiting the scope.

## Claims

1. An electrical component formed in a package, wherein the package comprises a base (10), a first set of layers (12a,14,12b) forming an enclosure, a connection lead structure (16) formed over the first set of layers (12a,14,12b) which connects to the component within the package and defines connection terminals outside the package, and a lid (18) over the connection lead structure,
wherein the connection lead structure extends laterally from the package and has a height step (30) at the location where the connection lead structure exits the package, wherein the size of the height step (30) is dependent on the sum of the thickness tolerance variations of the first set of layers and the base, such that after the height step (30), the height of the connection lead structure with respect to the base is independent of said thickness tolerance variations.

2. A component as claimed in claim 1, wherein the size of the height step (30) is less than one quarter of the sum of the thicknesses of the first set of layers and the base.

3. A component as claimed in claim 1 or 2, wherein the first set of layers comprise a first interconnect layer (12a) over the base (10), a dielectric ring (14) formed over the first interconnect layer (12a), and a second interconnect layer (12b) formed over the dielectric ring (14).

4. A component as claimed in any preceding claim, wherein the base (10) comprises a heat sink.

5. A component as claimed in any preceding claim, wherein the connection lead structure comprises a second height step (15) such that the bottom of the connection lead structure after the second height step (15) is level with the bottom of the base (10).

6. A component as claimed in any one of claims 1 to 4, wherein the connection lead structure is flat after the height step (30).

7. A circuit comprising:
a packaged electrical component as claimed in any one of claims 1 to 4;
a PCB (50) to which the lead connection terminals are connected outside the package.

8. A circuit as claimed in claim 7, wherein the PCB and the package are mounted over a common base (42), wherein the package is mounted in a recess (40) in the common base (42), and wherein the connection lead structure is flat after the height step (30).

9. A circuit as claimed in claim 7, wherein the PCB and the package are mounted over a planar common base (42), wherein the connection lead structure comprises a second height step (15) such that the bottom of the connection lead structure after the second height step (15) is level with the bottom of the base (10).

10. A method of forming a component package, comprising providing a base (10), a first set of layers (12a,14,12b) over the base forming an enclosure, a connection lead structure (16) over the first set of layers (12a,14,12b) and a lid (18) over the connection lead structure;
connecting the connection lead structure to a component within the package, wherein the connection lead structure defines connection terminals outside the package;
forming a height step (30) at a location where the connection lead structure exits the package using a tool which is positioned with reference to the base (10), wherein the size of the height is dependent on the sum of the thickness tolerance variations of the first set of layers and the base, such that after the height step (30), the height of the connection lead structure with respect to the base is independent of said thickness tolerance variations.

11. A method as claimed in claim 10, wherein the size of the height step (30) is less than one quarter of the sum of the thicknesses of the first set of layers and the base.

12. A method as claimed in claim 10 or 11, further comprising connecting the lead connection terminals outside the package to a PCB (50).

13. A method as claimed in claim 10, 11 or 12, further comprising forming second height step (15) such that the bottom of the connection lead structure after the second height step (15) is level with the bottom of the base (10).

14. A method as claimed in claim 12, comprising mounting the PCB and the package over a common base (42), wherein the common base has a recess, and the package is mounted in the recess (40), and wherein the connection lead structure is flat after the height step (30).

15. A method as claimed in claim 13, comprising mounting the PCB and the package over a planar common base (42), wherein the second height step (15) is such that the bottom of the connection lead structure after the second height step (15) is level with the bottom of the base (10).
